# EUROPÄISCHE PATENTSCHRIFT

(11) **EP 3 666 047 B1**
(45) Veröffentlichungstag und Bekanntmachung des Hinweises auf die Patenterteilung: **13.03.2024**
(21) Anmeldenummer: 18800554.0
(22) Anmeldetag: 02.11.2018
(51) Int. Cl.: H05K 7/20

(54) **KÜHLSYSTEM MIT PARALLELEN KÜHLKANÄLEN**
COOLING SYSTEM WITH PARALLEL COOLING CHANNELS
SYSTÈME DE REFROIDISSEMENT À CANAUX DE REFROIDISSEMENT PARALLÈLES

(30) Priorität: 27.11.2017 EP 17203775
(43) Veröffentlichungstag der Anmeldung: 17.06.2020
(73) Patentinhaber: Siemens Aktiengesellschaft, 80333 München (DE)
(72) Erfinder: KNAUER, Hans, 91359 Leutenbach (DE)
(74) Vertreter: Siemens Patent Attorneys
(86) Internationale Anmeldenummer: PCT/EP2018/080019
(87) Internationale Veröffentlichungsnummer: WO 2019/101494

(56) Entgegenhaltungen:
- EP-A1- 2 557 676
- EP-A2- 2 244 361
- EP-A2- 2 254 400
- US-A1- 2010 202 109
- US-A1- 2011 198 064
- US-A1- 2017 135 251

## Beschreibung

Die Erfindung betrifft ein Kühlsystem für einen Stromrichter. Ferner betrifft die Erfindung ein Stromrichter mit einem derartigen Kühlsystem. Weiter betrifft die Erfindung ein Verfahren zur Regelung und/oder Steuerung eines derartigen Kühlsystems oder derartigen Stromrichters.

Stromrichter zur Umwandlung von elektrischer Energie erzeugen Verlustleistung, die sich in Verlustwärme zeigen. Diese Wärme muss aus den entsprechenden Bauteilen abgeführt werden, um diese vor Beschädigungen zu schützen. In einem Stromrichter entsteht Verlustleistung im Besonderen im Leistungsteil. Dort werden unterschiedliche elektrische Komponenten eingesetzt, die sich im Betrieb aufgrund elektrischer Verluste erwärmen und gekühlt werden müssen um eine erforderliche Lebensdauer der Komponenten gewährleisten zu können. Dies sind im Wesentlichen die Halbleiter (z.B. IGBT's) und die Zwischenkreiskondensatoren. Da die Lebensdauer von Zwischenkreiskondensatoren sehr stark durch die Umgebungstemperatur beeinflusst wird, sollte diese ca. 70°C nicht übersteigen um Standardkomponenten verwenden zu können. Diese Standardkomponenten sind preisgünstig am Markt verfügbar und wirken sich auf niedrige Herstellkosten des Stromrichters aus.

Aufgrund der geringen zulässigen Umgebungstemperatur für die Zwischenkreiskondensatoren gibt es eine Vorgabe hinsichtlich der Anordnung in einem luftgekühlten Leistungsteil. Dabei werden die Zwischenkreiskondensatoren in einem Luftstrom zur Kühlung entweder vor den Halbleitern oder mittels Luft-Bypass angeordnet. So wird sichergestellt, dass sie mit kühler, d.h. nicht vorerwärmter, Kühlluft versorgt werden.

Aus der US 2010/202109 A1 ist ein Frequenzumrichter zum Antrieb eines Motors bekannt- Dieser umfasst eine Leiterplatte mit mindestens einem darauf montierten ersten wärmeerzeugenden Element, einen Kühlkörper, der mit dem mindestens einen ersten wärmeerzeugenden Element verbunden ist, einen Lüfter, der dem Kühlkörper zugewandt ist und eine Halterung zum Positionieren des mindestens einen wärmeerzeugenden Elements relativ zu dem Kühlkörper und der Leiterplatte. Der Frequenzumrichter umfasst ferner ein Trennelement zum Trennen des mindestens einen Abschnitts des Hauptkörpers des mindestens einen zweiten wärmeerzeugenden Elements von der Leiterplatte, um zu verhindern, dass die Kühlluft zu dem mindestens einen zweiten Wärmeerzeuger geleitet wird. Ferner umfasst der Frequenzumrichter ein Luftstromführungselement, das zwischen dem Lüfter und dem Kühlkörper angeordnet ist, um die vom Lüfter bewegte Kühlluft zu dem Kühlkörper bzw. zu dem mindestens einen zweiten wärmeerzeugenden Element zu leiten und ein Strömungsleittor, das den Luftstrom vom Lüfter zum Kühlkörper leitet und mehr Luftstrom abgibt, um durch den Bereich zu strömen, der dem mindestens einen ersten wärmeerzeugenden Element entspricht.

Aus der US 2011/198064 A1 ist eine Kühlstruktur für ein elektronisches Gerät mit einem Einlass zum Fördern einer Strömung in einer ersten Strömungsrichtung zu einer ersten Komponente und einem Auslass zum Weiterleiten der Strömung bekannt. Um zu verhindern, dass Schmutzpartikel zu elektronischen Bauteilen gelangen, kann die Kühlstruktur einen zweiten Strömungskanal umfassen, der von einer quer zur ersten Strömungsrichtung oder davon weg orientierten Öffnung ausgeht und einen Teil der Strömung vom Einlass aufnimmt und den Teil der Strömung zu einem elektronischen Bauteil fördert, das sich im zweiten Strömungskanal befindet.

Der Erfindung liegt die Aufgabe zugrunde ein Kühlsystem für einen Stromrichter zu verbessern.

Diese Aufgabe wird durch ein Kühlsystem für einen Stromrichter mit den Merkmalen des Anspruchs 1 gelöst. Ferner wird die Aufgabe durch einen Stromrichter mit den Merkmalen des Anspruchs 4 gelöst. Weiter wird diese Aufgabe durch ein Verfahren zur Regelung und/oder Steuerung mit den Merkmalen des Anspruchs 5 gelöst.

Vorteilhafte Ausgestaltungen der Erfindung sind in den abhängigen Ansprüchen angegeben.

Der Erfindung liegt die Erkenntnis zugrunde, dass eine gute Versorgung mit hinreichend kühlem Kühlmedium, beispielsweise mit Luft oder Wasser, durch eine parallele Anordnung von zwei Kühlkanälen zur Kühlung von Zwischenkreiskondensatoren und Halbleitern im Gerät erzielt werden kann. Die Halbleiter werden aufgrund der hohen schaltbaren Ströme auch als Leistungshalbleiter bezeichnet. Dazu werden für diese beiden unterschiedlichen Komponenten direkt angeströmte und hermetisch getrennte Kühlkanäle vorgesehen. Durch die beiden Kühlkanale werden sowohl Zwischenkreiskondensatoren als auch die Halbleiter mit einem nicht vorerwärmten Kühlmedium gekühlt. Für die Zwischenkreiskondensatoren hat dies den Vorteil, dass zulässige Maximaltemperaturen zuverlässig eingehalten werden. Gleichzeitig kann die deutlich höhere Verlustleistung der Halbleiter zuverlässig abgeführt werden. Eine gegenseitige Beeinflussung kann dabei auf einfache Weise durch die parallele Anordnung vermieden werden. Neben den thermischen Vorteilen kann mit den beiden Kühlkanälen auch ein relativ einfacher, niederinduktiver Geräteaufbau mit sehr einfachen Stromschienen zur Stromführung für die DC- und AC-Schienen erreicht werden. Aufgrund dieser Anordnung lässt sich das Bauvolumen des Gesamtgerätes sehr kompakt gestalten.

Dabei sind die Kühlkanale als Luftkanäle ausgebildet. Die Verwendung von Luft hat sich als besonders vorteilhaft erwiesen. Diese kann der Umgebung entnommen werden und mittels der Kühlkanäle den zu kühlenden Komponenten zugeführt werden. Eine Aufteilung der Kühlluft auf zwei parallele Kühlkanäle ist dabei problemlos möglich. Im Gegensatz zur Kühlung mit dem Kühlmedium Wasser kann auf einen Rückkühler, der die Wärme im Wasser an die Umgebung abgibt, verzichtet werden. Damit lässt sich ein besonders einfach aufgebautes und gleichzeitig sehr wirkungsvolles Kühlsystem realisieren.

Dabei weist das Kühlsystem einen Luftverteiler auf, wobei der Luftverteiler derart in vorteilhafter Weise derart ausgebildet ist, den Luftstrom zwischen dem ersten Kühlkanal und dem zweiten Kühlkanal im Verhältnis 90:10 aufzuteilen. Da die Zwischenkreiskondensatoren zwar eine möglichst geringe Temperatur des Kühlmediums benötigen aber die Verlustleistung in den Halbleitern deutlich größer ist als in den Zwischenkreiskondensatoren hat es sich als vorteilhaft erwiesen, den Gesamtluftstrom über einen Luftverteiler im Verhältnis von 90:10 (Luftmenge Halbleiter im Verhältnis zu Zwischenkreiskondensator) aufzuteilen. Untersuchungen haben ergeben, dass Aufteilungen im Bereich 80:20 bis 95:5 gute und vor allem gleichmäßige Kühlungsergebnisse mit sich bringen.

Dazu wird für die Aufteilung der Kühlluft auf den ersten und den zweiten Kühlkanal ein Messwert einer Temperatur herangezogen. Dazu weist das Kühlsystem einen Temperatursensor aus. Dieser Temperaturmesswert kann direkt oder nach Verarbeitung, beispielsweise nach Berechnungen in einem Temperaturmodell, für die Regelung bzw. Steuerung der Luftaufteilung zwischen den beiden Kühlkanälen verwendet werden. Der Temperatursensor kann dabei beispielsweise eine Temperatur einer im Kühlluftkanal befindlichen, zu kühlenden Komponente messen. Alternativ oder ergänzend kann auch die Temperatur der Kühlluft, insbesondere der Abluft, d.h. nachdem sie Wärme der zu kühlenden Komponente aufgenommen hat, gemessen werden und für die Regelung bzw. Steuerung der Aufteilung verwendet werden.

Der Vorteil der Luftaufteilung in Abhängigkeit von einem Temperaturmesswert liegt darin, dass die zu kühlenden Komponenten in den beiden Luftkanälen je nach Betriebsbedingungen optimal gekühlt werden können. Dabei kann beispielsweise die Aufteilung so ausgerichtet werden, dass der Lebensdauerverlust durch die Erwärmung der zu kühlenden Komponenten vergleichmäßigt wird. Alternativ oder ergänzend ist es möglich, sowohl die Luftmenge als auch die Aufteilung der Luft so zu regeln oder zu steuern, dass sich die Temperatur der zu kühlenden Komponenten einen Referenzwert annimmt und im Betrieb auf diesen Wert bleibt. Durch die Vermeidung von Temperaturschwankungen wird die Lebensdauer der zu kühlenden Komponenten erhöht.

Bei einer vorteilhaften Ausgestaltung der Erfindung weist das Kühlsystem genau einen Lüfter auf, der derart angeordnet ist, Kühlluftströme im ersten und im zweiten Kühlkanal zu erzeugen. Die gesamte benötigte Kühlluft für beide Luftkanäle kann bei dieser Ausgestaltung durch nur einen Lüfter an die Zwischenkreiskondensatoren und die Halbleiter herangeführt werden. Der Lüfter erzeugt dabei Kühlluftströme sowohl im ersten wie auch im zweiten Kühlkanal. Dabei wird die benötigte Kühlluft vom Lüfter in die beiden Kühlkanäle geblasen.

Der Luftverteiler kann dabei für die Aufteilung der Luft auf die beiden Kühlkanäle Öffnungen unterschiedlicher Größe aufweisen, so dass sich das entsprechende Aufteilungsverhältnis ergibt. Alternativ oder ergänzend können diese Öffnungen mit beweglichen Klappen ausgestattet sein, mit denen das Verhältnis der Aufteilung anpassbar ist. Der Vorteil der Anpassung liegt daran, dass auf unterschiedliche Verlustleistungsaufteilungen, beispielsweise abhängig vom Betriebspunkt des Stromrichters reagiert werden kann und die Kühlung für beide Komponenten optimal gestaltet werden kann. Die Aufteilung kann beispielsweise auch in Abhängigkeit der Temperatur der Zwischenkreiskondensatoren und/oder der Halbleiter gesteuert oder geregelt werden.

Eine weitere Möglichkeit, die Luftaufteilung auf die zwei Kühlkanäle vorzunehmen ist, ein Mittel zur Reduzierung des Drucks für mindestens einen der Kühlkanäle vorzusehen. Damit lässt sich ebenfalls auf einfache Weise die Aufteilung der Kühlluftmenge auf die beiden Kühlkanäle beeinflussen.

Bei einer weiteren vorteilhaften Ausgestaltung der Erfindung sind der erste und der zweite Kühlkanal im Bereich der parallelen Anordnung räumlich parallel angeordnet. Bei der räumlich parallelen Anordnung erstreckt sich die Außenhaut des ersten Kühlkanals zumindest abschnittsweise parallel zur Außenhaut des zweiten Kühlkanals. Durch die räumlich parallele Anordnung können auch die Zwischenkreiskondensatoren und die Halbleiter parallel zueinander im Stromrichter angeordnet werden. Damit lässt sich auch im Hinblick auf das elektrische Verhalten ein besonders einfacher und niederinduktiver Geräteaufbau mit sehr einfachen Stromschienen zur Stromführung für die DC- und AC-Schienen erzielen. Aufgrund dieser Anordnung lässt sich das Bauvolumen des Stromrichters sehr kompakt und damit kostengünstig gestalten.

Im Folgenden wird die Erfindung anhand der in den Figuren dargestellten Ausführungsbeispiele näher beschrieben und erläutert. Es zeigen:
- FIG 1: zwei Kühlkanäle eines Stromrichters und
- FIG 2: einen Stromrichter

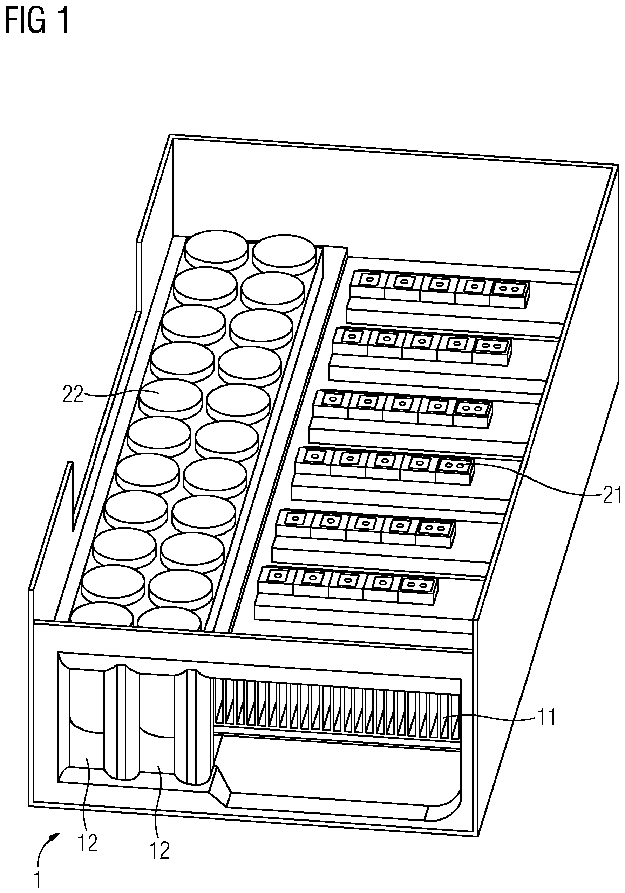

Die FIG 1 zeigt ein Kühlsystem 1 für die Verwendung des Kühlmediums Luft. Dieses Kühlsystem 1 weist einen ersten Kühlkanal 11 und einen zweiten Kühlkanal 12 auf. Diese erstrecken sich räumlich parallel durch den dargestellten Ausschnitt des Stromrichters 2. Deutlich zu erkennen sind die getrennten Kühlkanäle für die Kühlung der Halbleiter 21 und die Kühlung der Zwischenkreiskondensatoren 22. Dabei dient der erste Kühlkanal 11 zur Kühlung der Halbleiter 21, die auf einen Kühlkörper montiert sind. Die Kühlrippen des Kühlkörpers ragen in den ersten Kühlkanal 11. Damit geben die Halbleiter 21 die durch Verlustleistung erzeugte Wärme über den Kühlkörper an das Kühlmedium Luft ab. Eine Überhitzung der Halbleiter 21 kann somit zuverlässig verhindert werden.

Im zweiten Kühlkanal 12 sind die Zwischenkreiskondensatoren 22 angeordnet. Diese befinden sich im zweiten Kühlkanal 12 und werden von dem Kühlmedium Luft umspült. Dabei geben die Zwischenkreiskondensatoren 22 die Wärme ab, die aufgrund von Verlusten in den Kondensatoren entstehen. Da die Verlustleitung der Halbleiter 21 größer ist als die der Zwischenkreiskondensatoren 22 ist auch die wirksame Querschnittfläche des ersten Kühlkanals 11 größer als die wirksame Querschnittfläche des zweiten Kühlkanals 12. Die wirksame Querschnittsfläche ist die Querschnittsfläche des Kühlkanals 11, 12 abzüglich der darin hineinragenden Komponenten wie Zwischenkreiskondensatoren 22 oder Kühlrippen.

Zur Steuerung der Luftaufteilung zwischen den beiden Kühlkanälen 11, 12 dient ein hier nicht dargestellter Luftverteiler 4 am Eingang der beiden Kühlkanäle 11, 12. Mit diesem kann, beispielsweise abhängig vom Arbeitspunkt und/oder den an den Halbleitern 21 und/oder den Zwischenkreiskondensatoren 22 gemessenen Temperaturen, die Aufteilung der Kühlluft auf die beiden Kühlkanäle 11, 12 gesteuert oder geregelt werden.

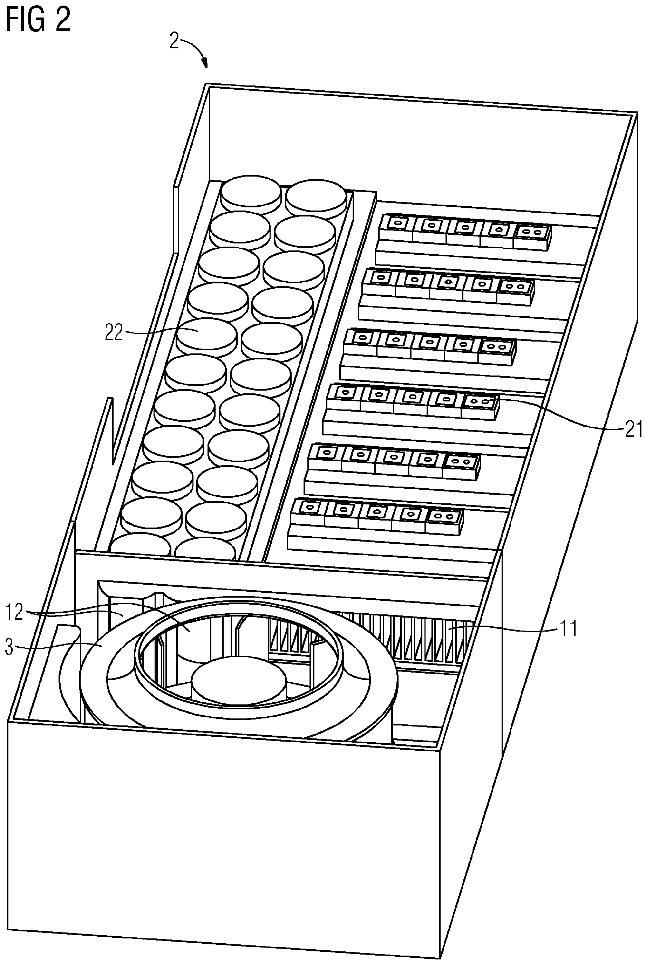

Die FIG 2 zeigt einen Stromrichter 2 mit einem Kühlsystem 1. Zur Vermeidung von Wiederholungen wird auf die Beschreibung zur FIG 1 sowie auf die dort eingeführten Bezugszeichen verwiesen. Zur Erzeugung eines Kühlluftstromes weist der Stromrichter 2 einen Lüfter 3 auf. Über den hier nicht dargestellten Luftverteiler 4 wird durch den Lüfter 3 ein Kühlluftstrom sowohl im ersten Kühlkanal 11 wie auch zweiten Kühlkanal 12 erzeugt.

Zusammenfassend betrifft die Erfindung ein Kühlsystem für einen Stromrichter. Zur Verbesserung des Kühlsystems wird vorgeschlagen, das Kühlsystem mit einem ersten Kühlkanal und einem zweiten Kühlkanal auszustatten, Wobei der erste und der zweite Kühlkanal zumindest abschnittsweise parallel angeordnet sind, wobei im Bereich der parallelen Anordnung der erste Kühlkanal zur Kühlung von Halbleitern des Stromrichters ausgebildet ist, wobei im Bereich der parallelen Anordnung der zweite Kühlkanal zur Kühlung von Zwischenkreiskondensatoren des Stromrichters ausgebildet ist. Ferner betrifft die Erfindung einen Stromrichter mit einem derartigen Kühlsystem.

## Patentansprüche

1. Kühlsystem (1) für einen Stromrichter (2), aufweisend
- einen ersten Kühlkanal (11)
- einen zweiten Kühlkanal (12)
wobei der erste und der zweite Kühlkanal (11,12) zumindest abschnittsweise parallel angeordnet sind, wobei im Bereich der parallelen Anordnung der erste Kühlkanal (11) zur Kühlung von Halbleitern (21) des Stromrichters (2) ausgebildet ist, wobei im Bereich der parallelen Anordnung der zweite Kühlkanal (12) zur Kühlung von Zwischenkreiskondensatoren (22) des Stromrichters (2) ausgebildet ist, wobei die Kühlkanale (11,12) als Luftkanäle ausgebildet sind, wobei das Kühlsystem (1) einen Luftverteiler aufweist,
**dadurch gekennzeichnet, dass** das Kühlsystem mindestens einen Temperatursensor aufweist, wobei der Luftverteiler derart ausgebildet ist, den Luftstrom zwischen dem ersten Kühlkanal (11) und dem zweiten Kühlkanal (12) in Abhängigkeit von mindestens einem Messwert des mindestens einen Temperatursensors im Verhältnis in einem Bereich von 80:20 bis 95:5 aufzuteilen.

2. Kühlsystem (1) nach Anspruch 1, wobei das Kühlsystem (1) genau einen Lüfter (2) aufweist, der derart angeordnet ist, Kühlluftströme im ersten und im zweiten Kühlkanal (11,12) zu erzeugen.

3. Kühlsystem (1) nach einem der Ansprüche 1 oder 2, wobei der erste und der zweite Kühlkanal (11,12) im Bereich der parallelen Anordnung räumlich parallel angeordnet sind.

4. Stromrichter (2) mit einem Kühlsystem (1) nach einem der Ansprüche 1 bis 3.

5. Verfahren zur Regelung und/oder Steuerung eines Kühlsystems (1) nach einem der Ansprüche 1 bis 3 oder eines Stromrichters (2) nach Anspruch 4, wobei die Aufteilung des Luftstroms in Abhängigkeit von einem Messwert des mindestens einen Temperatursensors erfolgt.

6. Verfahren nach Anspruch 5, wobei die Aufteilung des Luftstroms in Abhängigkeit von der Temperatur der in den jeweiligen Kühlkanälen befindlichen zu kühlenden Komponenten und/oder der Temperatur der Kühlluft in den jeweiligen Kühlkanälen erfolgt.

## Claims

1. Cooling system (1) for a power converter (2), having
- a first cooling channel (11)
- a second cooling channel (12)
wherein the first and the second cooling channel (11,12) are arranged in parallel, at least in sections, wherein in the region of the parallel arrangement the first cooling channel (11) is embodied for the cooling of semiconductors (21) of the power converter (2), wherein in the region of the parallel arrangement the second cooling channel (12) is embodied for the cooling of intermediate circuit capacitors (22) of the power converter (2), wherein the cooling channels (11,12) are embodied as air channels, wherein the cooling system (1) has an air distributor,
**characterised in that** the cooling system has at least one temperature sensor, wherein the air distributor is embodied so as to divide the air stream between the first cooling channel (11) and the second cooling channel (12) in the ratio in a range of 80:20 to 95:5 as a function of at least one measurement value of the at least one temperature sensor.

2. Cooling system (1) according to claim 1, wherein the cooling system (1) has precisely one fan (2), which is arranged so as to generate cooling air flows in the first and in the second cooling channel (11,12).

3. Cooling system (1) according to one of claims 1 or 2, wherein the first and the second cooling channel (11,12) are arranged spatially in parallel in the region of the parallel arrangement.

4. Power converter (2) with a cooling system (1) according to one of claims 1 to 3.

5. Method for regulating and/or controlling a cooling system (1) according to one of claims 1 to 3 or a power converter (2) according to claim 4, wherein the air flow is divided as a function of a measurement value of the at least one temperature sensor.

6. Method according to claim 5, wherein the air stream is divided as a function of the temperature of the components to be cooled situated in the respective cooling channels and/or the temperature of the cooling air in the respective cooling channels.

## Revendications

1. Système (1) de refroidissement d'un convertisseur (2) comprenant
- un premier conduit (11) de refroidissement
- un deuxième conduit (12) de refroidissement,
dans lequel le premier et le deuxième conduits (11, 12) de refroidissement sont disposés parallèlement au moins par tronçon, dans lequel dans la partie de l'agencement parallèle, le premier conduit (11) de refroidissement est constitué pour le refroidissement de semi-conducteurs (21) du convertisseur (2), dans lequel dans la partie de l'agencement parallèle, le deuxième conduit (12) de refroidissement est constitué pour le refroidissement de condensateurs (22) de circuit intermédiaire du convertisseur (2), dans lequel les conduits (11, 12) de refroidissement sont constitués sous la forme de conduits d'air, dans lequel le système (1) de refroidissement a un répartiteur d'air,
**caractérisé en ce que** le système de refroidissement a au moins une sonde de température, dans lequel le répartiteur d'air est constitué, de manière à subdiviser le courant d'air entre le premier conduit (11) de refroidissement et le deuxième conduit (12) de refroidissement en fonction d'au moins une valeur de mesure de la au moins une sonde de température, dans le rapport dans une plage de 80 : 20 à 95 : 5.

2. Système (1) de refroidissement suivant la revendication 1, dans lequel le système (1) de refroidissement a exactement un ventilateur (2), qui est disposé, de manière à produire des courants d'air de refroidissement dans le premier et dans le deuxième conduits (11, 12) de refroidissement.

3. Système (1) de refroidissement suivant l'une des revendications 1 ou 2, dans lequel le premier et le deuxième conduits (11, 12) de refroidissement sont disposés parallèlement dans l'espace dans la partie de l'agencement parallèle.

4. Convertisseur (2) comprenant un système (1) de refroidissement suivant l'une des revendications 1 à 3.

5. Procédé de régulation et/ou de commande d'un système (1) de refroidissement suivant l'une des revendications 1 à 3 ou d'un convertisseur (2) suivant la revendication 4, dans lequel on effectue la répartition du courant d'air, en fonction d'une valeur de mesure de la au moins une sonde de température.

6. Procédé suivant la revendication 5, dans lequel on effectue la répartition du courant d'air, en fonction de la température des composants à refroidir se trouvant dans les conduits de refroidissement respectifs et/ou de la température de l'air de refroidissement dans les conduits de refroidissement respectifs.
